## Europäisches Patentamt

## European Patent Office

## Office européen des brevets

(11) Veröffentlichungsnummer: **0 369 055**
**A1**

(12) **EUROPÄISCHE PATENTANMELDUNG**

(21) Anmeldenummer: **88119151.4**

(51) Int. Cl.⁵: **H03K 19/003**

(22) Anmeldetag: **17.11.88**

(43) Veröffentlichungstag der Anmeldung:
**23.05.90 Patentblatt 90/21**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**D-8000 München 2(DE)**

(72) Erfinder: **Harter, Johann, Dr.rer.nat.**
**Münchenerstrasse 9**
**D-8069 Reichertshausen(DE)**
Erfinder: **Pribyl, Wolfgang, Dr. Dipl.-Ing.**
**Kaltenbrunngasse 7**
**A-8043 Graz(AT)**

(54) **Schaltungsanordnung zur Kompensation von Rauschsignalen.**

(57) Die Schaltungsanordnung enthält eine Sensor-schaltung (I) zur Erfassung und Umformung von in einer Teilschaltung (IV) auftretenden Rauschsigna-len, eine Umsetzschaltung (II) zur Aufbereitung und Umsetzung der erfaßten Rauschsignale sowie ein Stellglied (III) zur Steuerung des Stromflusses in der Teilschaltung (IV). Die Schaltungsanordnung dient vorzugsweise der Kompensation solcher Rauschsi-gnale, die durch parasitäre Widerstände (R, R′) von Leiterbahnen verursacht sind, die mit Versorgungs-potentialen (VSS, VDD) verbunden sind.

## FIG 1

EP 0 369 055 A1

## Schaltungsanordnung zur Kompensation von Rauschsignalen

Die vorliegende Erfindung betrifft eine Schaltungsanordnung zur Kompensation von in einer Teilschaltung einer integrierten Halbleiterschaltung auftretenden Rauschsignalen.

Bei integrierten Schaltkreisen treten insbesondere auf Potentialleitungen unerwünschte Stromspitzen auf, die sich als Rauschsignale störend bemerkbar machen (sogenannter "On-chip-noise"). Die Rauschsignale gefährden die Funktionssicherheit der integrierten Halbleiterschaltung, weil sie Fehlschaltungen verursachen können. Das Auftreten der Rauschsignale ist insbesondere bei hoch- und höchstintegrierten Halbleiterschaltungen kritisch, weil deren elektrische Leiterbahnen minimale Strukturbreiten aufweisen. Eine Minimierung der Strukturbreite bedeutet jedoch automatisch eine Erhöhung der Gefahr des Auftretens der Rauschsignale.

In der Vergangenheit wurde deshalb häufig auf eine erwünschte und beispielsweise aus lithographischen Gesichtspunkten mögliche Minimierung der Strukturbreiten weitgehend verzichtet zugunsten der damit verbundenen Verringerung des Auftretens von Rauschsignalen.

Weiterhin wurde bislang erkannt, daß Rauschsignale insbesondere an Ausgangsstufen von Schaltungsteilen entstehen, da in Ausgangsstufen meist größere Ströme fließen (Ausgangs-"Treiber") als in sonstigen Schaltungsteilen integrierter Halbleiterschaltungen. Deshalb wurden häufig ständig wirkende strombegrenzende Maßnahmen vorgesehen. Dies führte jedoch zu einem entsprechenden Verlust an Arbeitsgeschwindigkeit, was wiederum unerwünscht ist.

Aufgabe der vorliegenden Erfindung ist es deshalb, den Einfluß von Rauschsignalen minimal zu halten, ohne dabei obengenannte Nachteile in Kauf nehmen zu müssen.

Diese Aufgabe wird gelöst durch die Merkmale der Schaltungsanordnung nach dem Patentanspruch 1. Vorteilhafte Aus- und Weiterbildungen sind in Unteransprüchen gekennzeichnet.

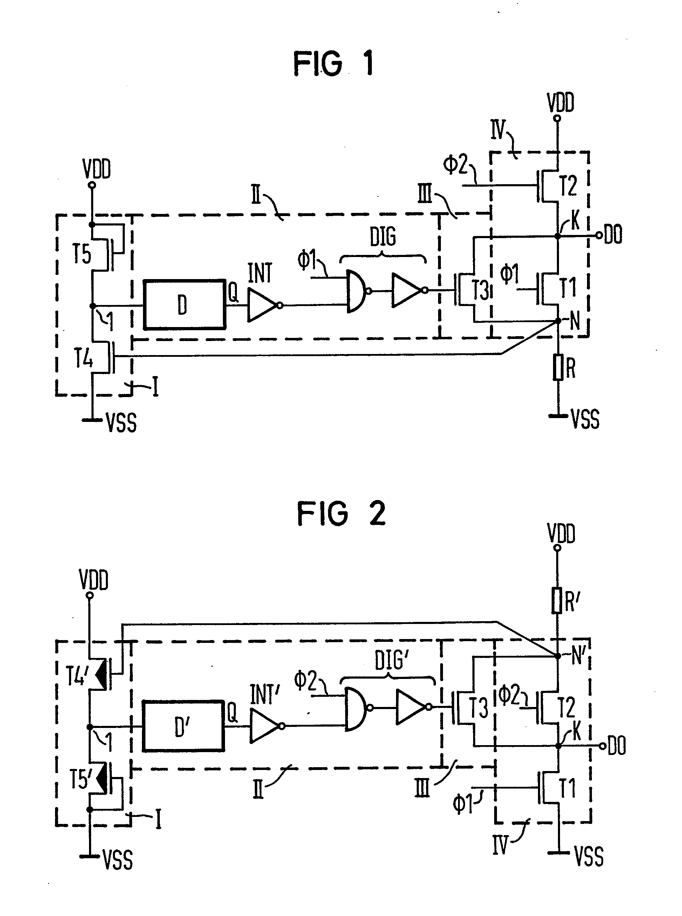

Die Erfindung wird nachstehend anhand der Figuren erläutert. Die FIG 1 und 2 zeigen beispielhafte Ausgestaltungen der Erfindung.

Als für Rauschsignale anfällige Teilschaltung IV einer integrierten Halbleiterschaltung ist in FIG 1 eine übliche NMOS-Ausgangsstufe mit Transistoren T1, T2 dargestellt. Die Transistoren T1, T2 werden gatemäßig, wie üblich, mit Signalen Ø1, Ø2 angesteuert, die die Ausgangspegel des an der Ausgangsstufe entstehenden Ausgangssignales DO bestimmen. Die Ausgangsstufe ist weiterhin, wie ebenfalls geläufig, mit einem ersten Versorgungspotential VSS und mit einem zweiten Versorgungspotential VDD verbunden. Das erste Versorgungspotential VSS sei dabei, gemäß einer für NMOS- und CMOS-Schaltungen international üblichen Nomenklatur, negativer als das zweite Versorgungspotential VDD. Der dargestellte Widerstand R bezeichnet symbolisch den grundsätzlich bei jeder Schaltung vorhandenen parasitären Widerstand von Leiterbahnen für das erste Versorgungspotential VSS. An diesem entstehen bei auftretenden Stromspitzen bzw. schnellen Stromänderungen aufgrund des Ohm'schen Gesetzes die gefürchteten Rauschsignale.

Der die Teilschaltung IV bildenden Ausgangsstufe sind eine Sensorschaltung I, eine Umsetzschaltung II und ein Stellglied III vorgeschaltet. Die Sensorschaltung I enthält vorzugsweise einen Transistor T4, dessen Source mit dem ersten Versorgungspotential VSS der Teilschaltung IV verbunden ist. Das Gate des Transistors T4 ist mit einer Stelle N verbunden, an der die zu kompensierenden Rauschsignale auftreten. Es ist somit über den parasitären Widerstand R, an dem im Betrieb aufgrund des Ohm'schen Gesetzes und der auftretenden Rauschsignale eine kleine, veränderliche Spannung abfällt, mit dem ersten Versorgungspotential VSS verbunden. Die Drain des Transistors T4 ist über eine Lasteinrichtung T5 ("Pull-up-Transistor") hochohmig mit dem zweiten Versorgungspotential VDD der Teilschaltung IV verbunden unter Bildung eines Ausganges 1 der Sensorschaltung I. Im Betrieb wird somit mittels des Gateanschlusses des Transistors T4 das zu kompensierende Rauschsignal an der Stelle N erfaßt und über die Source-Drain-Strecke des Transistors T4 umgeformt, so daß am Ausgang 1 ein dem Rauschsignal entsprechendes Signal anliegt. Dieses dient dann der Umsetzschaltung II als Eingangssignal.

Vorteilhafterweise beträgt die Einsatzspannung des Transistors T4 der Sensorschaltung I, die üblicherweise mit dem Symbol $U_T$ bezeichnet wird, höchstens 20 % der Differenz der beiden Versorgungspotentiale VDD und VSS. Noch günstiger ist ein Wert von maximal 10 %. Eine geringe Einsatzspannung $U_T$ ermöglicht eine hohe Empfindlichkeit der Schaltungsanordnung bezüglich der Rauschsignale und somit ein früheres Ansprechen ihrer Kompensationswirkung, was letzten Endes höhere Stromwerte in der Teilschaltung IV zuläßt.

Die Umsetzschaltung II enthält vorzugsweise eine Diskriminatorschaltung D mit nachgeschaltetem Integrator INT. Die Diskriminatorschaltung D kann insbesondere ein Flip-Flop enthalten. Der nachgeschaltete Integrator INT dient der Vermeidung von Schwingungen am Ausgang Q der Diskriminatorschaltung D. Der Eingang der Diskriminatorschaltung D ist mit Ausgang 1 der Sensorschaltung I verbunden. Die Umsetzschaltung II enthält weiterhin eine Digitalisierungsanordnung DIG, die die durch den Integrator INT aufintegrierten Störsignale unter Einbeziehung des die Teilschaltung IV ansteuernden Signales Ø1 in Digitalsignale umwandelt und diese dem Stellglied III als Eingangsgröße zur Verfügung stellt. Die Digitalisierungsanordnung DIG enthält vorzugsweise eine logische Gatteranordnung (in der FIG ist ein NAND-Gatter mit nachgeschaltetem Inverter dargestellt), die das Signal Ø1 und die Störsignale miteinander verknüpft und so die Digitalsignale erzeugt.

Das Stellglied III enthält vorzugsweise, wie in FIG 1 dargestellt, einen Transistor T3. Seine Source ist mit der Stelle N verbunden, an der die Rauschsignale entstehen. Seine Drain ist mit einem Schaltungsknoten K der Teilschaltung IV verbunden. Das Gate ist der Stelleingang des Stellgliedes III für die Digitalsignale der Digitalisierungsanordnung DIG. Im Betrieb werden bei Auftreten der Störsignale an der Stelle N durch gegenläufige Regelung des Stromflusses im Stellglied III die durch die Störsignale entstehenden Rauschsignale am Schaltungsknoten K kompensiert.

In FIG 2 ist eine Ausführung dargestellt, die der Kompensation von Rauschsignalen dient, die an solchen Anschlußstellen N′ der Teilschaltung IV entstehen, die mit dem anderen, gegenüber dem Potential VSS positiveren Versorgungspotential VDD verbunden sind. In Anpassung an die geänderten Polaritätsverhältnisse der einzelnen Transistoren (beispielsweise Sourceanschluß des Lasttransistors T5′ der Sensorschaltung I an das Versorgungspotential VSS anstelle von VDD) sind einige n-Kanal-Transistoren (nach FIG 1) durch entsprechende p-Kanal-Transistoren ersetzt. Den beiden FIG gemeinsamen Schaltelementen wurden gleiche Bezugszeichen zugeordnet. Unterschiedlichen, von der Funktion her jedoch gleichartigen Schaltelementen wurden in FIG 2 dem jeweiligen in der FIG 1 verwendeten Bezugszeichen ein Apostroph zugeordnet. Anhand der zu FIG 1 gegebenen Erläuterungen erübrigt sich für den Fachmann eine detaillierte Beschreibung von FIG 2, da diese Erläuterungen sinngemäß auch für FIG 2 gelten. Lediglich die Bezugszeichen VSS für das erste Versorgungspotential und VDD für das zweite Versorgungspotential in FIG 1 sind bei FIG 2 durch das jeweils andere Bezugszeichen ersetzt (d.h. also für FIG 2: erstes Versorgungspotential = VDD; zweites Versorgungspotential = VSS). Somit ist das erste Versorgungspotential VDD positiver als das zweite Versorgungspotential VSS, was konform geht mit der bei Fachleuten üblichen Nomenklatur. Weiter hin wird der Fachmann auch beide Ausführungsformen kombinieren und so Rauschsignale kompensieren, die an Anschlußstellen N und N′

entstehen.

**Ansprüche**

1. Schaltungsanordnung zur Kompensation von in einer Teilschaltung (IV) einer integrierten Halbleiterschaltung auftretenden Rauschsignalen mit folgenden Merkmalen:
- eine Sensorschaltung (I) zur Erfassung und Umformung der auftretenden Rauschsignale,
- eine Umsetzschaltung (II) zur Aufbereitung und Umsetzung der erfaßten Rauschsignale in logische Pegel und
- ein Stellglied (III) zur Steuerung des Stromflusses in der Teilschaltung (IV).

2. Schaltungsanordnung nach Anspruch 1, **dadurch gekennzeichnet,** daß die Sensorschaltung (I) einen Transistor (T4; T4′) und eine Last-Einrichtung (T5; T5′) enthält, daß die Source des Transistors (T4; T4′) mit einem ersten Versorgungspotential (VSS; VDD) der Teilschaltung (IV) verbunden ist, daß dessen Drain über die Last-Einrichtung (T5; T5′) hochohmig mit einem zweiten Versorgungspotential (VDD; VSS) verbunden ist und daß das Gate des Transistors (T4; T4′) mit einer Stelle (N; N′) verbunden ist, an der die zu kompensierenden Rauschsignale auftreten.

3. Schaltungsanordnung nach Anspruch 1 oder 2, **dadurch gekennzeichnet,** daß die Umsetzschaltung (II) enthält:
a) eine Diskriminatorschaltung (D;D′) mit nachgeschaltetem Integrator (INT;INT′), die die an einem Ausgang (1) der Sensorschaltung (I) anliegenden, durch die Sensorschaltung (I) umgeformten Rauschsignale als Störsignal bewerten und aufintegrieren, und
b) eine Digitalisierungsanordnung (DIG;DIG′), die die aufintegrierten Störsignale unter Einbeziehung eines die Teilschaltung (IV) ansteuernden Signales (Ø1; Ø2) in Digitalsignale umwandelt und diese dem Stellglied (III) als Eingangsgröße zur Verfügung stellt.

4. Schaltungsanordnung nach einem der vorhergehenden Ansprüche, **dadurch gekennzeichnet,** daß das Stellglied (III) einen Transistor (T3) enthält, dessen Source mit der Stelle (N; N′) verbunden ist, an der die Rauschsignale entstehen, dessen Drain mit einem Schaltungsknoten (K) verbunden ist, der innerhalb der Teilschaltung (IV) angeordnet ist, und dessen Gate einen Stelleingang des Stellgliedes (III) bildet.

5. Schaltungsanordnung nach einem der Ansprüche 1 bis 4, **dadurch gekennzeichnet,** daß das erste Versorgungspotential (VSS) negativer ist als das zweite Versorgungspotential (VDD).

6. Schaltungsanordnung nach einem der Ansprüche 1 bis 4, **dadurch gekennzeichnet,** daß das erste Versorgungspotential (VDD) positiver ist als das zweite Versorgungspotential (VSS).

7. Schaltungsanordnung nach einem der Ansprüche 2 bis 6, **dadurch gekennzeichnet**, daß die Einsatzspannung ($U_T$) des Transistors (T4; T4$'$) der Sensorschaltung (I) betragsmäßig höchstens 20 % der Differenz der beiden Versorgungspotentiale (VSS, VDD; VDD, VSS) ist.

8. Schaltungsanordnung nach einem der Ansprüche 2 bis 6, **dadurch gekennzeichnet**, daß die Einsatzspannung ($U_T$) des Transistors (T4; T4$'$) der Sensorschaltung (I) betragsmäßig höchstens 10 % der Differenz der beiden Versorgungspotentiale (VSS, VDD; VDD, VSS) ist.

9. Verwendung der Schaltungsanordnung nach einem der vorhergehenden Ansprüche, **dadurch gekennzeichnet**, daß sie zur Kompensation von solchen Rauschsignalen verwendet wird, die durch parasitäre Widerstände (R, R$'$) wenigstens einer Leiterbahn verursacht sind, die mit einem der Versorgungspotentiale (VSS; VDD) verbunden ist.

# FIG 1

# FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | PATENT ABSTRACTS OF JAPAN, Band 9, Nr. 212 (E-339)[1935], 29. August 1985; & JP-A-60 74 719 (NIPPON DENKI K.K.) 27-04-1985 * Figur * --- | 1 | H 03 K 19/003 |
| A | US-A-3 969 637 (MINAMI et al.) * Figuren 1,2; Spalten 1,2 * --- | 1 | |
| A | US-A-3 534 282 (DAY) * Figuren 4,7,8; Spalte 5, Zeile 9 - Spalte 6, Zeile 56 * --- | 1 | |
| A | EP-A-0 186 385 (UNISYS CORP.) --- | 1 | |
| A | GB-A-1 122 160 (ZELTEX INC.) --- | 1 | |
| A | US-A-4 575 650 (NAIMPALLY et al.) ----- | 1 | |

**RECHERCHIERTE SACHGEBIETE (Int. Cl.5)**

H 03 K
H 03 F

Der vorliegende Recherchenbericht wurde für alle Patentansprüche erstellt

| Recherchenort | Abschlußdatum der Recherche | Prüfer |
|---|---|---|
| DEN HAAG | 19-07-1989 | FEUER F.S. |